**Europäisches Patentamt**

**European Patent Office**

**Office européen des brevets**

(19)

(11) Veröffentlichungsnummer: **0 096 287
B1**

(12)

# EUROPÄISCHE PATENTSCHRIFT

(45) Veröffentlichungstag der Patentschrift:
**16.08.89**

(51) Int. Cl.⁴: **G 03 F 7/26**

(21) Anmeldenummer: **83105113.1**

(22) Anmeldetag: **24.05.83**

(54) Vorrichtung zum Behandeln von nach photochemischen Verfahren hergestellten Druckplatten.

(30) Priorität: **04.06.82 DE 3221257**

(43) Veröffentlichungstag der Anmeldung:
**21.12.83 Patentblatt 83/51**

(45) Bekanntmachung des Hinweises auf die Patenterteilung:
**16.08.89 Patentblatt 89/33**

(84) Benannte Vertragsstaaten:
**AT BE CH DE FR GB IT LI NL**

(56) Entgegenhaltungen:
**DE-A- 2 235 571
DE-A- 2 326 122
GB-A- 1 212 317
US-A- 2 677 320
US-A- 3 896 470**

**PATENTS ABSTRACTS OF JAPAN, Band 4, Nr. 77, 9.
Dezember 1980, Seite (P39) [659] & JP - A - 55 121 444
(HAJIME HONDA) 18.09.1980**

(73) Patentinhaber: **BASF Aktiengesellschaft,
Carl-Bosch-Strasse 38, D-6700 Ludwigshafen (DE)**

(72) Erfinder: **Hecke, Paul, Kornackerstrasse 20,
D-6700 Ludwigshafen (DE)**
Erfinder: **Buerger, Arnulf, Dr., Weimarer Strasse 8,
D-6700 Ludwigshafen (DE)**
Erfinder: **Werther, Heinz-Ulrich, Dr.,
Hans-Hoffmann-Strasse 12, D-6706 Wachenheim (DE)**

## Beschreibung

Die Erfindung betrifft eine Vorrichtung zum Behandeln von nach photochemischen Verfahren hergestellten Druckplatten, insbesondere von aus photopolymerisierbaren Stoffen hergestellten und mit aktinischem Licht bestrahlten Druckplatten, bei der die zu behandelnden Druckplatten von einer Eingabestation über eine Auswasch-, eine Reinigungs- und eine Trocknungsstation zu einer Ausgabestation mittels eines Systems von angetriebenen mit Velour oder Textilgeweben überzogenen Walzen transportiert werden und wobei die Druckplatten während des Transports durch die Auswasch- und Reinigungsstation mit der belichteten Seite nach oben zeigen, wobei auf der der belichteten Seite der durchlaufenden Druckplatten zugekehrten Seite mindestens ein quer zu der Transportrichtung hin- und herbewegtes ebenes Auswaschelement angeordnet ist. Derartige Vorrichtungen sind beispielsweise aus der US-A-3 896 470 und der DE-A-2 326 122 bekannt.

Nach photochemischen Verfahren hergestellte Druckplatten werden hauptsächlich im Zeitungs-, Verpackungs- und Akzidenzdruck verwendet.

Es ist bekannt, nach dem bildmäßigen Belichten der Druckplatten, diese mittels einer Auswaschflüssigkeit und über ein aus mehreren Düsen bestehendes Spülsystem oder senkrecht zu den belichteten Druckplatten angeordneter, rotierender, gegenläufig drehender Bürsten auszuwaschen, d.h. das Material der unbelichteten Bildbereiche der Druckplatten wird während des Auswaschvorganges von den belichteten Druckplatten entfernt.

Diese derzeit für Druckplatten hauptsächlich verwendete Vorrichtung hat jedoch verschiedene Nachteile, beispielsweise wird für den Auswaschvorgang sehr viel Auswaschflüssigkeit benötigt. Des weiteren ist für den Antrieb der die Auswaschflüssigkeit umwälzenden Pumpe eine hohe elektrische Leistung notwendig. Nachteilig für die Qualität der Zeitungs-, Verpackungs- und Akzidenzdrucke wirkt sich aus, daß beispielsweise durch die rotierenden Bürsten auf den Druckplatten auch belichtete Bildteile weggebürstet werden.

Der Erfindung liegt daher die Aufgabe zugrunde, die oben erwähnten Nachteile zu beseitigen, also den Verbrauch an Auswaschflüssigkeit und an elektrischer Energie zu senken und das plattenschädigende Bürsten der belichteten Druckplatten während des Auswaschvorganges durch ein die Druckplatten schonendes anderes Verfahren zu ersetzen.

Diese Aufgabe wird erfindungsgemäß dadurch gelöst, daß die Druckplatten während des Transports durch die Auswasch- und Reinigungsstation unterhalb des Niveaus der Auswaschflüssigkeit liegen und das Auswaschelement auf der der durchlaufenden Druckplatten zugekehrten Seite mit Velour überzogen ist.

Weitere Merkmale der erfindungsgemäßen Vorrichtung sind Gegenstand der Unteransprüche.

Ein Ausführungsbeispiel der Erfindung ist in der Zeichnung dargestellt und wird im folgenden näher beschrieben.

Es zeigen:

Figur 1 eine Ansicht der erfindungsgemäßen Vorrichtung,

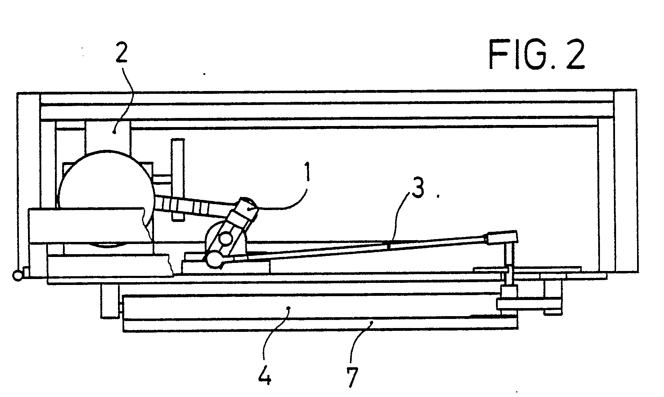

Figur 2 eine Seitenansicht der erfindungsgemäßen Vorrichtung, und

Figur 3 eine Einzelheit.

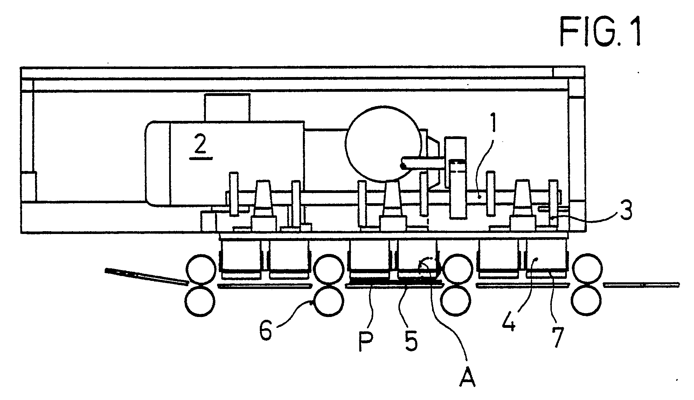

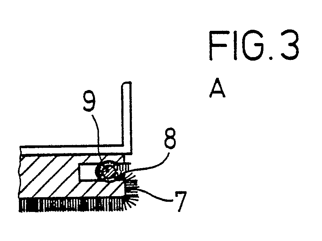

Figur 1 zeigt die Anordnung eines Pleuelgestänges 1 – angetrieben durch einen Getriebemotor 2 – mit sechs einzelnen Gestängen 3, an denen jeweils ein Auswaschelement 4 befestigt ist. Der Transport der Druckplatten erfolgt auf dem Tisch 5 mittels der angetriebenen Walzen 6. Auf die Unterseite des Auswaschelements 4 ist ein langfaseriges Gewebe 7 aufgespannt. Die Befestigung des langfaserigen Gewebes 7 ist aus Figur 3 ersichtlich. In den beiden quer zu der Transportrichtung verlaufenden Seiten des Auswaschelements 4 wird jeweils auf der gesamten Länge eine Nut 8 eingefräst, in die die Spannelemente 9 eingedrückt sind. Zwischen der Ober- und Unterfläche der Nut 8 einerseits und dem Spannelement 9 ist auf der gesamten Länge der Nut 8 das langfaserige Gewebe 7 – wie in Zeichnung 3 dargestellt – eingespannt.

Erläuternd zum Aufbau der erfindungsgemäßen Vorrichtung wird der Verfahrensablauf des Auswaschens der belichteten Druckplatten erläutert. Die belichtete Druckplatte wird mittels der angetriebenen Walzen und des Tisches durch die Auswasch- und Reinigungsstation transportiert. Die belichtete Seite der Druckplatte weist nach oben und ist in ihrer gesamten Fläche mit Auswaschflüssigkeit überspült.

Während des Transports der Druckplatte wird mittels des langfaserigen Gewebes, das durch die Art des Antriebes hin- und hergehende Bewegungen ausführt, und auf der Druckplatte aufliegt, das Material der unbelichteten Bildbereiche abgebürstet, das sich dann in der Auswaschflüssigkeit löst.

Die mit der Erfindung erzielten Vorteile bestehen insbesondere darin, daß gegenüber den bekannten Vorrichtungen zum Auswaschen weniger Auswaschflüssigkeit benötigt wird und der elektrische Energieverbrauch gesenkt werden konnte. Da das Auswaschen der unbelichteten Bildbereiche auf den Druckplatten mit der erfindungsgemäßen Vorrichtung schonender als mit rotierenden Bürsten erfolgt, ist die Gefahr auch belichtete Bildteile abzubürsten, entscheidend vermindert worden.

## Patentansprüche

1. Vorrichtung zum Behandeln von nach photochemischen Verfahren hergestellten Druckplatten, insbesondere aus photopolymerisierbaren Stoffen hergestellten und mit aktinischem Licht bestrahlten Druckplatten, bei der die zu behandelnden Druckplatten von einer Eingabestation über eine Auswasch-, eine Reinigungs- und eine Trocknungsstation zu einer Ausgabestation mittels eines Systems von angetriebenen mit Velour oder Textilgeweben überzogenen Walzen transportiert werden und wobei die Druckplatten während des Transports durch die Auswasch- und Reinigungsstation mit der belichteten Seite nach oben zeigen, wobei auf der der belichteten Seite der durchlaufenden Druckplatten zugekehrten Seite mindestens ein quer zu der Transportrichtung hin- und herbewegtes ebenes Auswaschelement angeordnet ist, dadurch gekennzeichnet, daß die Druckplatten während des Transports durch die Auswasch- und Reinigungsstation unterhalb des Niveaus der Auswaschflüssigkeit liegen und das Auswaschelement (4) auf der der durchlaufenden Druckplatten zugekehrten Seite mit Velour (7) überzogen ist.

2. Vorrichtung gemäß Anspruch 1, dadurch gekennzeichnet, daß in Transportrichtung der Druckplatten mindestens zwei zu einander gegenläufig bewegte Auswaschelemente (4) angeordnet sind.

3. Vorrichtung gemäß Anspruch 1 und 2, dadurch gekennzeichnet, daß das Auswaschelement (4) an den quer zu der Transportrichtung verlaufenden Seiten mit jeweils einer Nut (8) versehen ist, und der Velour (7) in den Nuten (8) mittels Spannelementen (9) befestigt ist.

## Claims

1. Apparatus for treating a printing plate produced by a photochemical process, in particular a printing plate produced from photopolymerizable substances and exposed to actinic light, in which the plate to be treated is transported from an input station, via a washout station, a cleaning station and a drying station, to an output station by means of a system of driven rollers covered with velour or textile fabrics, in which, during transport through the washout and cleaning stations, the exposed side of the plate faces upwards, and in which one or more flat washout elements are located so as to face the exposed side of the plate passing through, these washout elements moving to and fro at right angles to the direction of transport, wherein the printing plate during transport through the washout and cleaning stations is below the level of the washout liquid and the washout element (4) is covered with velour (7) on the side facing the plate passing through.

2. Apparatus as claimed in claim 1, wherein two or more washout elements (4) moving in opposite directions are arranged along the direction of transport of the printing plate.

3. Apparatus as claimed in claims 1 and 2, wherein the washout element (4) is provided with a groove (8) in reach of the sides which are at right angles to the direction of transport, and the velour (7) is attached in the grooves (8) by means of tensioning elements (9).

## Revendications

1. Appareil de traitement de clichés fabriqués par un procédé photochimique, en particulier de clichés en matières photopolymérisables et irradiés par de la lumière actinique, dans lequel les clichés à traiter sont transportés au moyen d'un système de rouleaux menés, revêtus de velours ou tissu textile, d'un poste d'entrée à un poste de sortie, en passant par un poste de lavage, un poste de nettoyage et un poste de séchage, et les clichés présentant pendant le transport par les postes de lavage et de nettoyage, leur face irradiée vers le haut, au moins un élément de lavage plan, déplacé en va et vient transversalement à la direction de transport, étant disposé sur le côté tourné vers la face irradiée des clichés en déplacement, caractérisé par le fait que les clichés se trouvent au-dessous du niveau du liquide de lavage pendant leur transport par les postes de lavage et de nettoyage et l'élément de lavage (4) est revêtu de velours sur la face tournée vers les clichés en déplacement.

2. Appareil selon la revendication 1, caractérisé par le fait que, dans la direction de transport des clichés, sont disposés au moins deux éléments de lavage (4) déplacés en sens inverses l'un de l'autre.

3. Appareil selon les revendications 1 et 2, caractérisé par le fait que l'élément de lavage (4) est muni d'une rainure (8) dans chacun des côtés s'étendant transversalement à la direction de transport et le velours (7) est fixé dans les rainures (8) au moyen d'éléments de serrage (9).

FIG.1

FIG. 2

FIG.3

A

9

8

7